Europäisches Patentamt

European Patent Office

Office européen des brevets

(19)

(11) Veröffentlichungsnummer: **0 215 280**
**B1**

(12) **EUROPÄISCHE PATENTSCHRIFT**

(45) Veröffentlichungstag der Patentschrift:
31.10.90

(51) Int. Cl.⁵: **H03K 19/096,** H03K 19/017,
H03K 5/02

(21) Anmeldenummer: 86110999.9

(22) Anmeldetag: 08.08.86

(54) Signalumsetzschaltung.

(30) Priorität: 09.08.85 DE 3528722

(43) Veröffentlichungstag der Anmeldung:
25.03.87 Patentblatt 87/13

(45) Bekanntmachung des Hinweises auf die Patenterteilung:
31.10.90 Patentblatt 90/44

(84) Benannte Vertragsstaaten:
AT BE CH DE FR GB IT LI NL SE

(56) Entgegenhaltungen:
DE-A- 2 840 329
DE-A- 3 220 063
DE-A- 3 324 030
JP-A-58 157 224
JP-A-58 186 227
US-A- 3 659 118
US-A- 4 185 209

PATENT ABSTRACTS OF JAPAN, Band 5,
Nr. 86 (E-60)[758], 5. Juni 1981; & JP - A - 56 34233
IBM-Technical Disclosure Bulletin, Band 27, No.10B,
März 1986, Seiten 6023-6024

(73) Patentinhaber: Siemens Aktiengesellschaft,
Wittelsbacherplatz 2, D-8000 München 2(DE)

(72) Erfinder: Hofmann, Rüdiger, Dr.-rer. nat., Fürstenfelder
Weg 12, D-8031 Gilching(DE)

ACTORUM AG

## Beschreibung

Bei hoch- und höchstintegrierten (VLSI-) Bausteinen tritt häufig das Problem auf, daß angelieferte kleinhubige Eingangssignale, beispielsweise TTL-Signale, in großhubige Ausgangssignale, beispielsweise Signale zum Ansteuern von C-MOS-Bausteinen, umgesetzt werden müssen.

Zur Umsetzung eines TTL-Taktsignals in ein MOS-Taktsignal ist (aus DE-A 1 32 20 063) eine Taktumsetzschaltung bekannt, die eine TTL-Eingangsinverterstufe, eine Rücksetztaktstufe mit drei Invertern und eine Leistungstaktstufe aufweist, die ihrerseits aus einer Schaltstufe, einer Verzögerungsstufe mit zwei Invertern und einer Endstufe mit ebenfalls zwei Invertern besteht, wobei die Rücksetztaktstufe und die Leistungsstufe direkt von der Eingangsinverterstufe aktiviert werden und die Rücksetztaktstufe zwei Rücksetzsignale an die Leistungsstufe liefert. Diese bekannte Signalumsetzschaltung, die an sich eine relativ verlustleistungsarme Taktumsetzung in großhubige Taktsignale mit steilen Signalflanken bei hoher Belastung ermöglicht, ist in ihrer Empfindlichkeit und damit in ihrer Schnelligkeit insofern begrenzt, als sie auf Änderungen des Eingangssignals jeweils erst dann reagiert, wenn dieses mit seiner jeweiligen Signalflanke eine Ansprechschwelle in Höhe der (üblicherweise bei 2,5 Volt liegenden) halben Drain-Source-Speisespannung über- bzw. unterschritten hat.

Demgegenüber stellt sich die Erfindung die Aufgabe, eine merklich empfindlichere und damit schnellere Signalumsetzschaltung anzugeben.

Die Erfindung geht dabei davon aus, daß (aus JP-A 56-34233, FIG 2) bereits eine Schaltungsanordnung zur Umsetzung von kleinhubigen Eingangssignalen in großhubige Ausgangssignale mit einer an ihrem Eingang mit einem Taktsignal beaufschlagten C-MOS-Inverterschaltung und einem zwischen deren MOS-Transistor des einen Kanaltyps und die zugehörige Speisepotentialquelle eingefügten MOS-Transistor gleichen Kanaltyps bekannt ist, der an seiner Steuerelektrode mit dem Eingangssignal beaufschlagt ist. Diese bekannte Schaltungsanordnung sieht keine gleichzeitige Bildung zweier zueinander komplementärer Ausgangssignale vor. In der Praxis werden aber vielfach zueinander komplementäre Signale gleicher Zeitlage benötigt, und die Erfindung zeigt einen Weg, kleinhubige Eingangssignale in zueinander komplementäre großhubige Ausgangssignale gleicher Zeitlage umzusetzen.

Die Erfindung betrifft eine Schaltungsanordnung zur Umsetzung von kleinhubigen Eingangssignalen in großhubige Ausgangssignale, insbesondere zum Ansteuern von C-MOS-Bausteinen mit TTL- oder ECL-Signalen, mit einer Signalübernahmeschaltung mit einer an ihrem Eingang mit einem Taktsignal beaufschlagten C-MOS-Inverterschaltung und einem zwischen deren MOS-Transistor des einen Kanaltyps und die zugehörige Speisepotentialquelle eingefügten MOS-Transistor gleichen Kanaltyps, der an seiner Steuerelektrode mit dem Eingangssignal beaufschlagt ist. Diese Schaltungsanordnung ist erfindungsgemäß dadurch gekennzeichnet, daß die Signalübernahmeschaltung eine an ihrem Eingang mit dem Taktsignal beaufschlagte weitere C-MOS-Inverterschaltung und einen zwischen deren MOS-Transistor des einen Kanaltyps und die zugehörige Speisepotentialquelle eingefügten MOS-Transistor gleichen Kanaltyps aufweist, der mit seiner Steuerelektrode an die Ausgangselektrode des genannten, an seiner Steuerelektrode mit dem Eingangssignal beaufschlagten MOS-Transistor angeschlossen ist, und daß eine der Signalübernahmeschaltung nachgeschaltete Leistungsstufe mit zwei C-MOS-Inverterschaltungen an die Ausgänge der beiden zuvor genannten C-MOS-Inverterschaltungen angeschlossen ist.

Es sei an dieser Stelle bemerkt, daß (aus IBM Technical Disclosure Bulletin 27(1985)10B, 6023-6024) bereits eine Schaltungsanordnung zur Umsetzung von kleinhubigen Eingangssignalen in großhubige Ausgangssignale bekannt ist, die mit einer nachgeschalteten Leistungsstufe mit einer C-MOS-Inverterschaltung versehen ist.

Es sei ferner bemerkt, daß (aus US-A-4 185 209, FIG 1) eine statische UND-Schaltungsanordnung für zwei großhubige Eingangssignale bekannt ist, die ein Paar zueinander parallelgeschalteter p-Kanal-Transistoren und ein dazu in Serie geschaltetes Paar zueinander in Serie geschalteter n-Kanal-Transistoren sowie einen am Verbindungspunkt von Parallelschaltung und Serienschaltung angeschlossenen Inverter aufweist.

Des weiteren ist (aus Patent Abstract JP-A 58-186 227) eine taktgesteuerte AND-Schaltung für drei großhubige Eingangssignale bekannt, bei der eine Serienschaltung dreier Logik-Transistoren zwischen zwei C-MOS-Abtast-Transistoren liegt.

Eine ähnliche Schaltungsstruktur weist auch eine (aus Patent Abstract JP-A-58-157 224) bekannte Schaltungsanordnung zur Spannungspegelumsetzung auf.

Nähere Berührungspunkte mit der vorliegenden Erfindung sind bei diesen bekannten Schaltungen nicht gegeben.

Die Erfindung, die neben dem Vorteil eines der geringen Anzahl notwendiger Transistoren entsprechenden geringen Platzbedarfs die mit der Ausbildung der Signalübernahmestufe als dynamisch betriebene Schaltungsstufe verbundenen weiteren Vorteile einer hohen, lediglich durch die (etwa bei 0,5 bis 1,2 Volt) liegende Schwellenspannung des mit dem Eingangssignal beaufschlagten MOS-Inverters bestimmten Empfindlichkeit und einer darauf basierenden hohen Einstellgeschwindigkeit mit sich bringt, die sich je nach der Dimensionierung im Bereich einiger bis zu etwa 10 Nanosekunden bewegen mag, ermöglicht vorteilhafterweise die gleichzeitige, d.h. phasengleiche, Gewinnung zweier zueinander komplementärer großhubiger Ausgangssignale aus einem kleinhubigen Eingangssignal.

Um auch bei größeren (kapazitiven) Ausgangslasten die Belastung der Signalübernahmeschaltung gering zu halten, kann in weiterer Ausgestaltung der Erfindung der Leistungsstufe eine Ausgangsstufe mit zwei mit den genannten zwei weiteren C-MOS-Inverterschaltungen verbundenen Einkanal-MOS-Gegentakt-Ausgangsschaltungen nachgeschaltet sein; alternativ dazu ist es auch möglich, daß der Leistungsstufe eine Ausgangsstufe mit zwei mit den genannten zwei weiteren C-MOS-Inverterschaltungen verbundenen Einkanal-MOS-Sourcefolger-Ausgangsschaltungen mit Flip-Flop-Rückkopplung ihrer Treibertransistoren nachgeschaltet ist.

Um der bei einer Ansteuerung dynamisch betriebener Schaltungen manchmal bestehenden Forderung Rechnung zu tragen, daß in Taktpausen beide Komplementärausgänge der Schaltungsanordnung ein "0"-Signal führen, kann die Schaltungsanordnung in weiterer Ausgestaltung der Erfindung dahingehend ausgebildet sein, daß ihren beiden Komplementärausgängen gleichzeitig das dem einen Signalzustand entsprechende Ausgangssignal über zwei mit dem negierten Taktsignal gesteuerte Schalttransistoren aufprägbar ist.

Anhand der Zeichnung sei die Erfindung noch näher erläutert. Dabei zeigt

FIG 1 ein Ausführungsbeispiel einer Signalumsetzschaltung gemäß der Erfindung;
FIG 2 läßt den Signalverlauf an den entsprechend bezeichneten Schaltungspunkten erkennen. In
FIG 3 und FIG 4 sind weitere Ausgestaltungen der Schaltungsanordnung nach FIG 1 verdeutlicht.

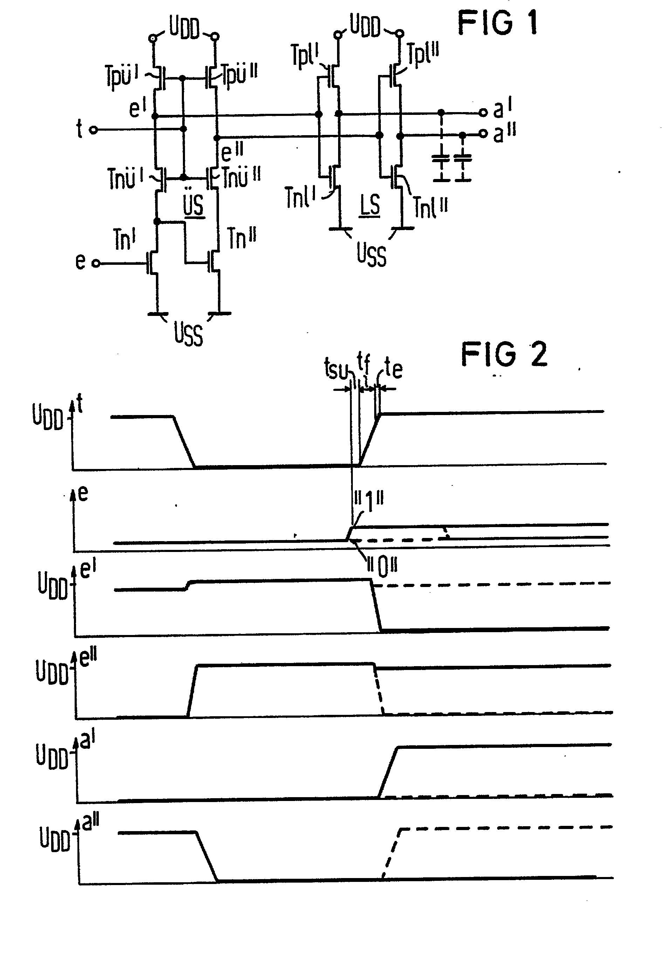

Die in FIG 1 skizzierte Signalumsetzschaltung weist zunächst eine Signalübernahmeschaltung ÜS auf, die eine mit einem p-Kanal-MOS-(Verarmungs-) Transistor Tpü' und einem n-Kanal-MOS-(Anreicherungs-)Transistor Tnü' gebildete, an ihrem Eingang t mit einem Taktsignal (t in FIG 2) beaufschlagte C-MOS-Inverterschaltung sowie einen zwischen deren einen MOS-Transistor Tnü' und die zugehörige Speisepotentialquelle Uss (Masse) eingefügten MOS-Transistor Tn' gleichen Typs enthält, der an seiner Steuerelektrode mit dem umzusetzenden kleinhubigen Eingangssignal (e in FIG 2) beaufschlagt wird. Der Signalübernahmeschaltung ÜS ist eine Leistungsstufe LS mit einer an den Ausgang e' der genannten C-MOS-Inverterschaltung Tpü', Tnü' angeschlossenen weiteren C-MOS-Inverterschaltung Tpl', Tnl' nachgeschaltet.

Zusätzlich dazu enthält die Signalübernahmeschaltung ÜS auch eine mit einem p-Kanal-MOS-(Verarmungs-)Transistor Tpü" und einem n-Kanal-MOS-(Anreicherungs-)Transistor Tnü" gebildete, an ihrem Eingang t mit dem Taktsignal (t in FIG 2) beaufschlagte C-MOS-Inverterschaltung sowie einen zwischen deren einen MOS-Transistor Tnü" und die zugehörige Speisepotentialquelle Uss (Masse) eingefügten MOS-Transistor Tn" gleichen Typs, der mit seiner Steuerelektrode an die Ausgangselektrode des seinerseits an seiner Steuerelektrode mit dem Eingangssignal (e in FIG 2) beaufschlagten MOS-Transistors Tn' gleichen Typs angeschlossen ist. In entsprechender Weise ist in der der Signalübernahmeschaltung ÜS nachgeschalteten Leistungsstufe LS eine an den Ausgang e" der C-MOS-Inverterschaltung Tpü", Tnü" angeschlossene weitere C-MOS-Inverterschaltung Tpl", Tnl" vorgesehen.

Die in FIG 1 skizzierte Signalumsetzschaltung, der an ihren Betriebsspannungsklemmen Udd eine Betriebsspannung von beispielsweise +5 Volt zugeführt werden möge, arbeitet dann folgendermaßen:

Es sei angenommen, daß in der Signalübernahmeschaltung ÜS bei einem am Takteingang t (in FIG 1) anstehenden Taktsignal gemäß FIG 2t von etwa +5 Volt die beiden p-Kanal-Transistoren Tpü' und Tpü" der beiden C-MOS-Inverterschaltungen Tpü', Tnü' und Tpü", Tnü" nichtleitend und deren beide n-Kanal-Transistoren Tnü' und Tnü" leitend sind und daß sich dabei bei aufgrund eines (früheren) Eingangssignals e (in FIG 2e) etwa von maximal 0,8 Volt nichtleitendem n-Kanal-Transistor Tn' und leitendem n-Kanal-Transistor Tn" am Inverterausgang e' der einen C-MOS-Inverterschaltung ein Potential von etwa 4,6 Volt ausgebildet hat und am Inverterausgang e" der anderen C-MOS-Inverterschaltung das Potential 0 Volt (Masse). Bei dieser Konstellation sind in der Leistungsstufe LS der p-Kanal-Transistor Tpl' der einen C-MOS-Inverterschaltung Tpl', Tnl' und der n-Kanal-Transistor Tnl" der anderen C-MOS-Inverterschaltung Tpl", Tnl" nichtleitend und der n-Kanal-Transistor Tnl' der einen C-MOS-Inverterschaltung und der p-Kanal-Transistor Tpl" der anderen C-MOS-Inverterschaltung leitend; am Ausgang a' der Schaltungsanordnung tritt dann ein "0"-Ausgangssignal gemäß FIG 2a' von 0 Volt (Masse) auf und am Komplementärausgang a" gemäß FIG 2a" das Udd-Potential von +5 Volt.

Springt das am Takteingang t (in FIG 1) anstehende Taktsignal gemäß FIG 2t auf 0 Volt, so werden in der Signalübernahmeschaltung ÜS die beiden p-Kanal-Transistoren Tpü' und Tpü" leitend und die beiden n-Kanal-Transistoren Tnü' und Tnü" nichtleitend mit der Folge, daß an beiden Inverterausgängen e' und e" das Udd-Potential von +5 Volt auftritt; in der Leistungsstufe LS sind dann beide p-Kanal-Transistoren Tpl' und Tpl" nichtleitend und beide n-Kanal-Transistoren Tnl' und Tnl" leitend, so daß an beiden Schaltungsausgängen a' und a" das "0"-Signal-Potential 0 Volt (Masse) auftritt.

Springt danach das am Takteingang t (in FIG 1) auftretende Taktsignal gemäß FIG 2t wieder auf den Wert Udd von im Beispiel +5 Volt, so wird mit der ansteigenden Taktflanke das am Eingang e der Schaltungsanordnung nach FIG 1 anstehende Eingangssignal, wie es in FIG 2e skizziert ist, abgetastet:
Ist, wie dies in FIG 2e mit der durchgehenden Linie dargestellt ist, zu dieser Zeit am Schaltungseingang e (FIG 1) ein Eingangssignal "1" etwa von 2,0 Volt gegeben, aufgrund dessen der n-Kanal-Transistor Tn' der Signalübernahmeschaltung ÜS leitend ist, so gelangt mit dem durch das Taktsignal bewirkten Leitendwerden des n-Kanal-Transistors Tnü' der C-MOS-Inverterschaltung Tpü', Tnü' deren Ausgang e' auf das (Masse-)Potential von 0 Volt; andererseits wird der n-Kanal-Transistor Tn" nichtleitend, so daß trotz Leitendwerden des n-Kanal-Transistors Tnü" das Potential am Inverterausgang e" der C-MOS-Inverterschaltung Tpü", Tnü" sich nur unwesentlich, etwa von 5 Volt auf 4,6 Volt, ändert. In der Leistungsstufe LS sind dann der p-Kanal-Transistor Tpl' der einen C-MOS-Inverterschaltung Tpl', Tnl' und der n-Kanal-Transistor Tnl" der anderen C-MOS-Inverterschaltung Tpl", Tnl" leitend und der n-Kanal-Transistor Tnl' der einen C-MOS-Inverterschaltung und der p-Kanal-Transistor Tpl" der anderen C-MOS-Inverterschaltung nichtleitend; am Ausgang a' der Schaltungsanordnung tritt dann das "1"-Signal-Potential von im Beispiel 5 Volt auf und am Ausgang a" das (Masse-)Potential von 0 Volt.

Ist dagegen, wie dies in FIG 2e gestrichelt dargestellt ist, zu der Signalübernahmezeit am Schaltungseingang e (in FIG 1) ein Eingangssignal "0" etwa von 0,8 Volt gegeben, aufgrund dessen der damit an seiner Gate-Elektrode beaufschlagte n-Kanal-Transistor Tn' nichtleitend ist, so ändert sich bei nichtleitendwerdendem p-Kanal-Transistor Tpü' und leitendwerdendem n-Kanal-Transistor Tnü' das Potential am Inverterausgang e' der einen C-MOS-Inverterschaltung Tpü', Tnü' nur unwesentlich (etwa von 5 Volt auf 4,6 Volt), während umgekehrt über den nunmehr leitenden n-Kanal-Transistor Tn" bei nichtleitend werdendem p-Kanal-Transistor Tpü" und leitendwerdendem n-Kanal-Transistor Tnü" der anderen Inverterschaltung deren Inverterausgang e" auf das (Masse-)Potential von 0 Volt gelangt. In entsprechender Weise sind dann in der Leistungsstufe LS die Transistoren Tpl" und Tnl' leitend und die Transistoren Tpl' und Tnl" nichtleitend, so daß am Schaltungsausgang a' das "0"-Signal-Potential von 0 Volt und am Schaltungsausgang a" das $U_{DD}$-Potential von 5 Volt auftritt.

Die dynamische Signalübernahmeschaltung ÜS gemäß FIG 1 gestattet die mit der jeweils einen Taktflanke eines einzigen Taktsignals vor sich gehende Signalübernahme auch von kleinhubigen, mit ihrem Pegel etwas über der etwa bei 0,5 bis 1,2 Volt liegenden Schwellspannung des n-Kanal-Treibertransistors Tn' liegenden "1"-Eingangssignalen und besitzt somit eine hohe Empfindlichkeit; gleichzeitig weist die Signalübernahmeschaltung ÜS auch eine hohe Einstellgeschwindigkeit auf: Nach Ablauf einer kurzen, im Bereich weniger bis zu etwa 10 Nanosekunden liegenden Einstellzeit $t_{SU} + t_F + t_E$ (siehe FIG 2t), die sich aus einer Signal-Set-up-Zeit $t_{su}$, der Taktflankendauer $t_f$ und einer durch Schaltungskapazitäten bedingten Entladezeit $t_e$ der Inverterausgänge e', e" zusammensetzt, ist die Signalübernahmeschaltung ÜS jeweils eingestellt und ist damit das jeweilige Eingangssignal e (in FIG 2e) übernommen.

Kommt es nach der Übernahme eines "1"-Eingangssignals zu einem "1"-"0"-Übergang des Eingangssignals, wie dies in FIG 2e punktiert angedeutet ist, so hat dies ein Nichtleitendwerden des n-Kanal-Transistors Tn' zur Folge, was indessen am Inverterausgang e' zu keiner Potentialänderung führt; zusätzlich bleibt auch der n-Kanal-Transistor Tn" nichtleitend, so daß auch am Inverterausgang e" keine Potentialänderung eintritt. Nach der Übernahme eines Eingangssignals "1" durch die Signalübernahmeschaltung ÜS kann das Eingangssignal also in einem sogenannten return-to-zero-Betrieb wieder in den "0"-Signalzustand zurückgehen.

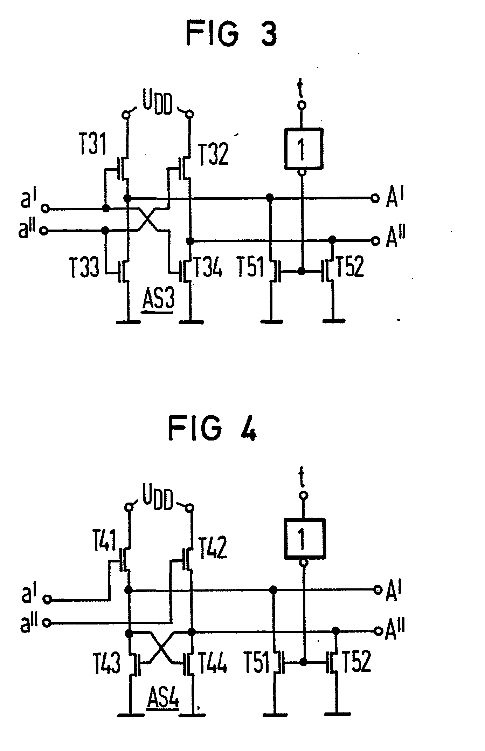

Die in FIG 1 skizzierte Schaltungsanordnung, in der die an den beiden C-MOS-Inverterausgängen e' und e" auftretenden großhubigen C-MOS-Signale (FIG 2e' und FIG 2e"), in die das von der Signalübernahmeschaltung ÜS mit der (im Ausführungsbeispiel ansteigenden) einen Flanke des Taktsignals (FIG 2t) übernommene Eingangssignal (FIG 2e) umgesetzt wird, in der nachfolgenden Leistungsstufe LS jeweils invertiert und leistungsverstärkt werden, kann an ihren Ausgangsklemmen a', a" mit merklichen kapazitiven Ausgangslasten beschaltet werden, die je nach Dimensionierung etwa bis zu 3 pF gehen können. Für höhere kapazitive Ausgangsbelastungen wird, um die Signalübernahmeschaltung ÜS nicht zu sehr zu belasten, zweckmäßigerweise der Leistungsstufe LS eine Ausgangs-Treiberstufe nachgeschaltet. Eine solche Ausgangsstufe kann, wie die in FIG 3 skizzierte Ausgangsstufe AS3, zwei mit den zwei C-MOS-Inverterschaltungen Tpl', Tnl' und Tpl", Tnl" (in FIG 1) verbundene Einkanal-MOS-Gegentakt-Ausgangsschaltungen T31, T33 und T32, T34 aufweisen. Eine andere Möglichkeit zeigt FIG 4 mit einer Ausgangsstufe AS4, die zwei mit den zwei C-MOS-Inverterschaltungen der Leistungsstufe LS (in FIG 1) verbundene Einkanal-MOS-Sourcefolger-Ausgangsschaltungen T41, T43 und T42, T44 mit Flip-Flop-Rückkopplung ihrer Treibertransistoren T43 und T44 aufweist.

Wie dies beispielsweise auch in FIG 3 und FIG 4 skizziert ist, kann in jedem Falle ein dem einen Signalzustand entsprechendes Ausgangssignal (Massepotential) über zwei mit dem negierten Taktsignal gesteuerte Schalttransistoren T51, T52 gleichzeitig beiden Komplementärausgängen (A', A" in FIG 3 und FIG 4; a', a" in FIG 1) aufgeprägt werden.

Die Erfindung, die immer dort Anwendung finden kann, wo kleinhubige Eingangssignale in großhubige Signale hoher Belastbarkeit umgesetzt werden müssen, wie dies etwa beim Ansteuern von C-MOS-Bausteinen mit TTL- bzw. ECL-Signalen der Fall sein kann, wurde im Vorstehenden anhand eines Ausführungsbeispiels erläutert, das in der Signalübernahmeschaltung jeweils zwischen dem n-Kanal-Transistor der jeweiligen C-MOS-Inverterschaltung und der zugehörigen Speisepotentialquelle $U_{SS}$ einen n-Kanal-Transistor vorsieht. Es sei indessen bemerkt, daß abweichend davon aber auch eine Signalübernahmeschaltung mit einem zwischen dem p-Kanal-Transistor der jeweiligen C-MOS-Inverterschaltung und der zugehörigen Speisepotentialquelle $U_{DD}$ (in FIG 1) eingefügten p-Kanal-Transistor vorgesehen sein kann, in der die Übernahme eines Eingangssignals dann mit der abfallenden Taktsignalflanke vor sich geht, ohne daß dies hier indessen noch weiter ins Einzelne gehend erläutert werden müßte.

**Patentansprüche**

1. Schaltungsanordnung zur Umsetzung von kleinhubigen Eingangssignalen in großhubige Ausgangssignale, insbesondere zum Ansteuern von C-MOS-Bausteinen mit TTL- oder ECL-Signalen, mit einer Signalübernahmeschaltung (ÜS) mit einer an ihrem Eingang mit einem Taktsignal (t) beaufschlagten C-MOS-Inverterschaltung (Tpü', Tnü') und einem zwischen deren MOS-Transistor (Tnü') des einen Kanaltyps und die zugehörige Speisepotentialquelle (Uss) eingefügten MOS-Transistor (Tn') gleichen Kanaltyps, der an seiner Steuerelektrode mit dem Eingangssignal (e) beaufschlagt ist, dadurch gekennzeichnet, daß die Signalübernahmeschaltung (ÜS) eine an ihrem Eingang mit dem Taktsignal (t) beaufschlagte weitere C-MOS-Inverterschaltung (Tpü", Tnü") und einen zwischen deren MOS-Transistor (Tnü") des einen Kanaltyps und die zugehörige Speisepotentialquelle (Uss) eingefügten MOS-Transistor (Tn") gleichen Kanaltyps aufweist, der mit seiner Steuerelektrode an die Ausgangselektrode des genannten, an seiner Steuerelektrode mit dem Eingangssignal (e) beaufschlagten MOS-Transistor (Tn') angeschlossen ist, und daß eine der Signalübernahmeschaltung (ÜS) nachgeschaltete Leistungsstufe (LS) mit zwei C-MOS-Inverterschaltungen (Tpl', Tnl'; Tpl", Tnl") an die Ausgänge der beiden zuvor genannten C-MOS-Inverterschaltungen (Tpü, Tnü'''; Tpü", Tnü") angeschlossen ist.

2. Schaltungsanordnung nach Anspruch 1, dadurch gekennzeichnet, daß der Leistungsstufe (LS) eine Ausgangsstufe (AS3) mit zwei mit den genannten zwei weiteren C-MOS-Inverterschaltungen (Tpl'; Tnl'; Tpl", Tnl") verbundenen Einkanal-MOS-Gegentakt-Ausgangsschaltungen (T31, T33; T32, T34) nachgeschaltet ist.

3. Schaltungsanordnung nach Anspruch 1, dadurch gekennzeichnet, daß der Leistungsstufe (LS) eine Ausgangsstufe (AS4) mit zwei mit den genannten zwei weiteren C-MOS-Inverterschaltungen (Tpl'; Tnl'; Tpl", Tnl") verbundenen Einkanal-MOS-Sourcefolger-Ausgangsschaltungen (T41, T43; T42, T44) mit Flip-Flop-Rückkopplung ihrer Treibertransistoren (T43; T44) nachgeschaltet ist.

4. Schaltungsanordnung nach einem der Ansprüche 1 bis 3, dadurch gekennzeichnet, daß ihren beiden Komplementärausgängen (a', a"; A', A") gleichzeitig das dem einen Signalzustand entsprechende Ausgangssignal über zwei mit dem negierten Taktsignal gesteuerte Schalttransistoren (T51, T52) aufprägbar ist.

**Claims**

1. Circuit arrangement for translating small-stroke input signals into large-stoke output signals, preferably for driving CMOS modules with TTL signals or ECL signals, comprising a signal acceptance circuit (ÜS) with a CMOS inverter circuit (Tpü', Tnü'), to which a clock signal (t) is applied at its input, and a MOS transistor (Tn'), which is inserted between the MOS transistor (Tnü'), of one channel type, of said inverter circuit, said transistor (Tn') being of the same channel type, and the associated supply voltage source (Uss) and to which the input signal (e) is applied at its gate electrode, characterized in that the signal acceptance circuit (ÜS) has a further CMOS inverter circuit (Tpü", Tnü"), to which the clock signal (t) is applied at its input, and a MOS transistor (Tn"), which is inserted between the MOS transistor (Tnü"), of one channel type, of said inverter circuit, said transistor (Tn") being of the same channel type, and the associated supply voltage source (Uss) and is connected with its gate electrode to the output electrode of the named MOS transistor (Tn') to the gate electrode of which the input signal (e) is applied, and in that a power stage (LS) downstream of the signal acceptance circuit (ÜS) and having two CMOS inverter circuits (Tpl', Tnl'; Tpl", Tnl") is connected to the outputs of the two previously named CMOS inverter circuits (Tpü', Tnü'; Tpü", Tnü").

2. Circuit arrangement according to Claim 1, characterized in that downstream of the power stage (LS) there is an output stage (AS3) having two single-channel MOS push-pull output circuits (T31, T33; T32, T34) connected to the named two further CMOS inverter circuits (Tpl', Tnl'; Tpl", Tnl").

3. Circuit arrangement according to Claim 1, characterized in that downstream of the power stage (LS) there is an output stage (AS4) having two single-channel MOS source-follower output circuits (T41, T43; T42, T44) with flipflop feedback of their driver transistors (T43; T44), connected to the named two further CMOS inverter circuits (Tpl', Tnl'; Tpl", Tnl").

4. Circuit arrangement according to one of Claims 1 to 3, characterized in that the output signal corresponding to one signal state can be impressed on the two complementary outputs (a', a"; A', A") of said circuit arrangement simultaneously via two switching transistors (T51, T52) controlled by the negated clock signal.

**Revendications**

1. Montage pour convertir des signaux d'entrée de faible amplitude en des signaux de sortie de grande amplitude, notamment pour la commande de modules C-MOS avec des signaux TTL ou ECL, comportant un circuit (ÜS) de prise en charge des signaux, comportant un circuit inverseur C-MOS (Tpü', Tnü') chargé sur son entrée par un signal de cadence (t), et un transistor MOS (Tn'), qui est inséré entre le transistor MOS (Tnü'), possédant un premier type de canal, de ce circuit inverseur, et la source associée de potentiel d'alimentation (Uss), le transistor MOS (Tn') possédant le même type de canal et étant chargé, au niveau de son électrode de commande, par le signal d'entrée (e), caractérisé par le fait que le circuit (ÜS) de prise en charge des signaux possède un autre circuit inverseur C-MOS (Tpü", Tnü"), chargé, sur son entrée, par le signal de cadence (e), et un transistor MOS (Tn"), inséré entre le transistor MOS (Tnü″) possédant un premier type de canal, de ce circuit inverseur, et la source associée de potentiel d'alimentation (U<sub>SS</sub>), le transistor MOS (Tn″) possédant le même type de canal et son l'électrode de commande étant raccordée à l'électrode de sortie dudit transistor MOS (Tn′), dont l'électrode de commande est chargée par le signal d'entrée (e), et

qu'un étage de puissance (LS) branché en aval du circuit (ÜS) de prise en charge des signaux et comportant deux circuits inverseurs C-MOS (Tpl′, Tnl′; Tpl″, Tnl″) est raccordé aux sorties des deux circuits inverseurs C-MOS mentionnés précédemment (Tpü″, Tnü″, Tpü″, Tnü″).

2. Montage suivant la revendication 1, caractérisé par le fait qu'en aval de l'étage de puissance (LS) est branché un étage de sortie (AS3) comportant deux circuits de sortie symétriques MOS à un canal (T31, T33; T32, T34) reliés auxdits deux autres circuits inverseurs C-MOS (Tpl′, Tnl′; Tpl″, Tnl″).

3. Montage suivant la revendication 1, caractérisé par le fait qu'en aval de l'étage de puissance (LS) est branché un étage de sortie (AS4) comportant deux circuits de sortie MOS à un canal montés en sources suiveuses (T41, T43; T42, T44), qui sont reliés auxdits deux autres circuits inverseurs CMOS (Tpl′, Tnl′, Tpl″, Tnl″), et dont les transistors d'attaque (T43; T44) sont couplés par une réaction créant une bascule bistable.

4. Montage suivant l'une des revendications 1 à 3, caractérisé par le fait que le signal de sortie correspondant à un état de signal peut être appliqué simultanément, aux deux sorties complémentaires (a′, a″; A′, A″) du montage, par l'intermédiaire de deux transistors de commutation (T51, T52) commandés par le signal de cadence négativé.

FIG 1

FIG 2

# FIG 3

# FIG 4